# EUROPEAN PATENT APPLICATION

(11) **EP 2 922 110 A1**
(43) Date of publication of application: **23.09.2015**
(21) Application number: 14185493.5
(22) Date of filing: 19.09.2014
(51) Int. Cl.: H01L 51/52, H01L 27/32

(54) **Light emitting module and lighting apparatus**

(30) Priority: 20.03.2014 JP 2014058921
(71) Applicant: Toshiba Lighting & Technology Corporation, Yokosuka-shi Kanagawa 237-8510 (JP); Kabushiki Kaisha Toshiba, Minato-ku Tokyo 105-8001 (JP)
(72) Inventor: Kaneko, Takashi, Kanagawa, 237-8510 (JP); Hayashi, Junya, Kanagawa, 237-8510 (JP); Sawabe, Tomoaki, Tokyo (JP)
(74) Representative: Bokinge, Ole

(57) **Abstract**

According to one embodiment, there is provided a light emitting module (15) including a light emitting panel (10) and a reflection portion (43). The light emitting panel (10) includes a first electrode (21), a second electrode (22), and an organic layer (30). The second electrode (22) faces the first electrode (21). The second electrode (22) has a power supply portion (22a) and a light transmission portion (22b). The organic layer (30) is provided between the first electrode (21) and the second electrode (22). The organic layer (30) has a light emitting layer (32). The reflection portion (43) is provided so as to face the first electrode (21) of the light emitting panel (10).

## Description

### FIELD

Embodiments described herein relate generally to a light emitting module and a lighting apparatus.

### BACKGROUND

For example, an organic light emitting diode (OLED) is included in a light emitting module and a lighting apparatus as a light source. Among others, generally, a cathode which is configured with an opaque material such as silver and aluminum and has a shape including suitable apertures such as stripes, and an anode which is formed with ITO and has a transmission property interpose an organic layer therebetween, thereby configuring an OLED. While being off, the OLED exhibits the transmission property, that is, both the anode side and the cathode side can be seen from the opposite side thereof via the OLED. While being on, one side emits light and the other side exhibits the transmission property, that is, the anode side emits light and the cathode side can be seen from the opposite side via the OLED.

Here, generally, an OLED has a tetragonal shape. In a case of a circular shape or a shape including an arc, the cutting method or the structure of the element itself needs to be reexamined, resulting in a disadvantage to produce a variant light emitting OLED. Since various uses are expected for the OLED, there is a demand for an OLED which acquires innovative light emissions.

### BRIEF DESCRIPTION OF THE DRAWINGS

FIGS. 1A and 1B are a set of schematic diagrams illustrating a light emitting module according to a first embodiment;
FIGS. 2A and 2B are a set of schematic diagrams illustrating a portion of the light emitting module according to the first embodiment;
FIGS. 3A and 3B are another set of schematic diagrams illustrating the light emitting module according to the first embodiment;
FIGS. 4A to 4C are a set of schematic diagrams illustrating a lighting apparatus according to the first embodiment.
FIGS. 5A and 5B are a set of schematic diagrams illustrating the light emitting module according to a second embodiment.
FIGS. 6A and 6B are another set of schematic diagrams illustrating the light emitting module.

### DETAILED DESCRIPTION

In general, according to one embodiment, a light emitting module includes a light emitting panel and a reflection portion. The light emitting panel includes a first electrode, a second electrode, and an organic layer. The second electrode faces the first electrode. The second electrode has a power supply portion and a light transmission portion. The organic layer is provided between the first electrode and the second electrode. The organic layer has a light emitting layer. The reflection portion is provided so as to face the first electrode of the light emitting panel.

Hereinafter, each of the exemplary embodiments described herein will be described with reference to the drawings.

The drawings are schematic and conceptual so that a relationship between a thickness and a width in each portion, a ratio of sizes between portions, and the like are not necessarily the same as those in reality. Even when illustrating the same portion, dimensions or ratios may be differently illustrated depending on the drawing.

In the specification described herein and in each drawing, the same reference numerals and signs are applied to similar elements already mentioned regarding the previously described drawings, thereby appropriately omitting the detailed descriptions thereof.

### First Embodiment

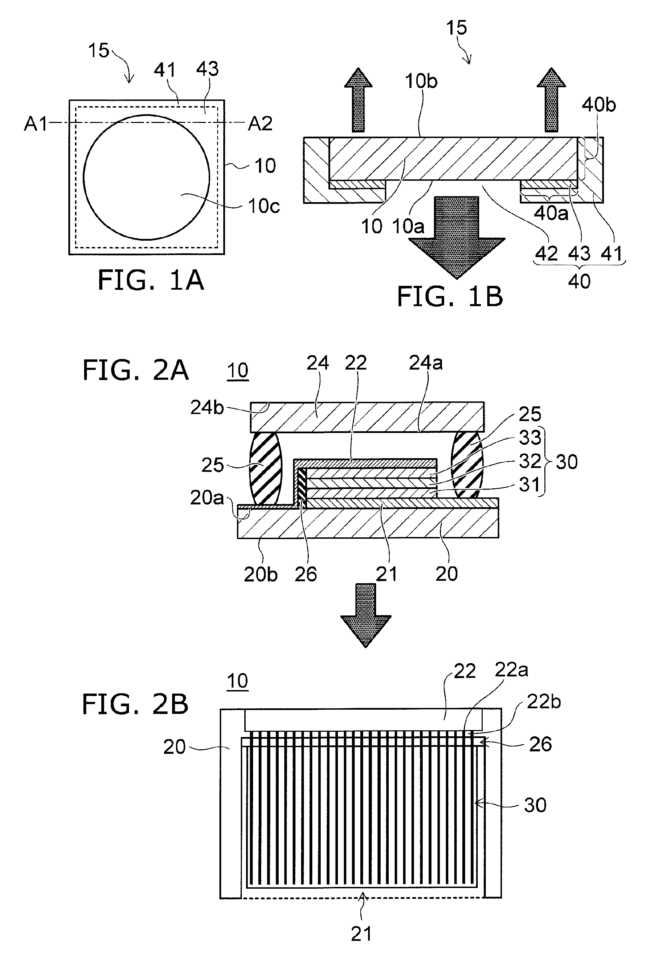

FIGS. 1A and 1B are a set of schematic diagrams exemplifying a light emitting module according to a first embodiment.

FIG. 1A is a schematic plan view exemplifying a light emitting module 15. FIG. 1B exemplifies a cross section taken along line A1-A2 of FIG. 1A.

The light emitting module 15 includes a light emitting panel 10 and a casing 40 (a contour of the module). The light emitting panel 10 has a first surface 10a and a second surface 10b. The second surface 10b is a surface on a side opposite to the first surface 10a. For example, the first surface 10a and the second surface 10b have tetragonal shapes. The first surface 10a includes a light emitting surface 10c.

The light emitting panel 10 is accommodated in the casing 40. For example, an end portion of the light emitting panel 10 comes into contact with the casing 40. The casing 40 includes a body portion 41, an opening portion 42, and a reflection portion 43.

The casing 40 has a first surface 40a that comes into contact with a portion on the first surface 10a of the light emitting panel 10 via the reflection portion 43. The casing 40 has a second surface 40b that comes into contact with a side surface of the light emitting panel 10. The first surface 40a and the second surface 40b are formed in the body portion 41. The light emitting panel 10 comes into contact with the casing 40 on the first surface 40a and the second surface 40b, and thus, the light emitting panel 10 is held by the casing 40.

For example, an anode, the organic layer, and a cathode are formed in one base substrate. A plurality of light emitting panels 10 are formed by sealing the base substrate and a sealing member. The plurality of light emitting panels 10 are cut by using a scribe apparatus and the like to be individually divided.

As illustrated in FIG. 1A, the light emitting surface 10c of the light emitting panel 10 has, for example, a circular shape (including a round shape and an elliptical shape). The first surface 10a of the light emitting panel 10 has a tetragonal shape. The opening portion 42 of the casing 40 is formed to have a circular shape, and thus, the light emitting surface 10c of the light emitting panel 10 is formed to have the circular shape.

The reflection portion 43 is formed on the first surface 40a of the casing 40 so as to face a portion on the first surface 10a of the light emitting panel 10. For example, the reflection portion 43 is formed between the light emitting panel 10 and the body portion 41 so as to come into contact with the portion on the first surface 10a of the light emitting panel 10. The reflection portion 43 is formed inside the casing 40 that is installed on an irradiation surface side of the light emitting panel 10.

For example, the reflection portion 43 is formed to have an arbitrary shape on the first surface 40a of the casing 40 so as to face at least one corner portion and the like on the first surface 10a of the light emitting panel 10. In the embodiment described herein, the reflection portion 43 has a square shape of which a central region is circularly hollowed. The reflection portion 43 is formed on the first surface 40a of the casing 40 so as to face each of the corner portions and end edges on the first surface 10a of the light emitting panel 10.

For example, the reflection portion 43 can be formed to have an arbitrary shape on the first surface 40a of the casing 40 so as to face the end portion on the first surface 10a of the light emitting panel 10. The reflection portion 43 may be formed to have a rectangular shape on the first surface 40a of the casing 40 so as to face at least one of four sides on the first surface 10a of the light emitting panel 10.

For example, the reflection portion 43 may be formed to have a frame shape on the first surface 40a of the casing 40 so as to face a peripheral edge portion on the first surface 10a of the light emitting panel 10. The reflection portion 43 may be formed on the first surface 40a of the casing 40 so as to face a portion excluding the light emitting surface 10c on the first surface 10a of the light emitting panel 10. The reflection portion 43 can be formed to have an arbitrary shape inside the casing 40 that is installed on the irradiation surface side of the light emitting panel 10.

Irradiation light applied from the first surface 10a of the light emitting panel 10 is specularly reflected or diffusely reflected by the reflection portion 43 which is formed on the first surface 40a of the casing 40. The light reflected by the reflection portion 43 goes around to the second surface 10b side of the light emitting panel 10.

For example, the reflection portion 43 is formed by providing a sheet made of silver (Ag), aluminum (Al), or the like on the first surface 40a of the casing 40. The reflection portion 43 is preferable to have specular reflectivity so that irradiation light applied from the first surface 10a of the light emitting panel 10 is specularly reflected by the reflection portion 43. The term "specular reflectivity" denotes that incident light at an incident angle θ is reflected at a reflection angle θ on a surface. However, the denotation includes a slight tolerance of the reflection angle, such as θ ± 5°. The reflection portion 43 may be formed through aluminum vapor deposition, separately from the casing 40.

For example, the reflection portion 43 allows a structure of micro-irregularity and a white diffuse reflection paint such as magnesium oxide or barium sulfate to be provided on the first surface 40a of the casing 40. When the reflection portion 43 is formed in such a manner, the irradiation light applied from the first surface 10a of the light emitting panel 10 is diffusely reflected by the reflection portion 43.

For example, the reflection portion 43 is formed on the first surface 40a of the casing 40 so as to specularly reflect mainly the irradiation light applied from the first surface 10a of the light emitting panel 10. Since the irradiation light applied from the first surface 10a of the light emitting panel 10 is specularly reflected by the reflection portion 43, a method of providing the reflection portion 43 on the first surface 40a of the casing 40 is adopted.

The reflection portion 43 may be formed on an end surface of the light emitting panel 10, that is, a thickness portion of the panel. In this case, since light leaking from the end surface can be utilized, light emitting efficiency is improved. For example, the reflection portion 43 may be provided to interpose a refractive index adjustment member between the reflection portion 43 and the light emitting panel 10. When a substrate of the light emitting panel 10 is made of glass, an optical member such as refractive index adjustment oil having a refractive index of approximately 1.5 can be adopted. Accordingly, wave-guiding can be performed inside the glass substrate so as to guide out light that is not able to be guided out.

FIGS. 2A and 2B are a set of schematic cross-sectional views exemplifying a portion of the light emitting module according to the first embodiment.

FIG. 2A illustrates a cross-sectional view of the light emitting panel 10. FIG. 2B illustrates a plan view of the light emitting panel 10.

A substrate 20, a first electrode 21, a second electrode 22, an organic layer 30, a sealing member 24, a sealing body 25, and an insulation film 26 are provided in the light emitting panel 10. The organic layer 30 includes a light emitting layer 32.

The substrate 20 has a first surface 20a and a second surface 20b. The second surface 20b is a surface on a side opposite to the first surface 20a. The sealing member 24 has a first surface 24a and a second surface 24b. The second surface 24b is a surface on a side opposite to the first surface 24a. The first surface 20a of the substrate 20 faces the first surface 24a of the sealing member 24. For example, the first surfaces 20a and 24a, and the second surfaces 20b and 24b have tetragonal shapes.

The second surface 20b of the substrate 20 corresponds to the first surface 10a of the light emitting panel 10. The second surface 24b of the sealing member 24 corresponds to the second surface 10b of the light emitting panel 10.

For example, the second electrode 22 is provided on the substrate 20. The first electrode 21 is provided between the second electrode 22 and the substrate 20. The organic layer 30 is provided between the first electrode 21 and the second electrode 22. The insulation films 26 are provided between a side surface of the organic layer 30 and the second electrode 22, and between an end portion of the first electrode 21 and the second electrode 22.

The sealing member 24 is provided on the substrate 20. The sealing body 25 is provided between the substrate 20 and the sealing member 24. The sealing body 25 is continuously provided around a region between the substrate 20 and the sealing member 24.

For example, the substrate 20 has a light transmission property. For example, the substrate 20 is a transparent substrate. For example, a glass substrate is adopted as the substrate 20. For example, a transparent resin substrate (for example, transparent plastic substrate) is adopted as the substrate 20.

The first electrode 21 has the light transmission property. For example, the first electrode 21 is a transparent electrode. For example, indium tin oxide (ITO), indium zinc oxide (IZO), or a conductive polymer is adopted as the first electrode 21.

For example, a silver (Ag) film or an aluminum (Al) film is adopted as the second electrode 22. Therefore, light transmittance thereof is lower than the light transmittance of the substrate 20. For example, the light transmittance of the second electrode 22 is lower than the light transmittance of the first electrode 21. For example, the second electrode 22 has a light reflection property.

The second electrode 22 has a light reflection portion 22a and a light transmission portion 22b. The light reflection portion 22a is a film that functions to supply power and to reflect light. The light transmission portion 22b is a portion that transmits light. In the embodiment described herein, the light transmission portion 22b is an opening. The opening can be acquired by forming the second electrode 22 to have a thin wire shape or a grid shape. Since the transmission property can be acquired by thinning the thickness of a metallic film, for example, the light transmission portion 22b may be formed by setting the silver film to have the thickness of 10 nm to 30 nm, and the light reflection portion 22a may be formed by setting the silver film to have the thickness of 30 nm to 200 nm. The widths and ratios of the light reflection portion 22a and the light transmission portion 22b are adjustable as desired.

For example, a positive hole transport layer 31, a light emitting layer 32, and an electron transport layer 33 are provided in the organic layer 30. For example, the positive hole transport layer 31 is provided on the first electrode 21. The light emitting layer 32 is provided on the positive hole transport layer 31. The electron transport layer 33 is provided on the light emitting layer 32. For example, the second electrode 22 is also provided on a portion of a front surface of the substrate 20. The second electrode 22 is continuously provided so as to cover a step difference between the front surface of the substrate 20 and an upper surface of the organic layer 30.

For example, in the light emitting panel 10, electrons are injected from the second electrode 22 to the light emitting layer 32 via the electron transport layer 33. For example, positive holes are injected from the first electrode 21 to the light emitting layer 32 via the positive hole transport layer 31. In the light emitting layer 32, the injected electrons and the injected positive holes are recombined. In response to the recombination thereof, the light emitting layer 32 radiates light.

In the specification described herein, the term "transparent" indicates that the light emitting layer 32 has the transmission property with respect to light. The term "transparent" does not limit the light transmittance thereof to be 100%. For example, the term "transparent" denotes that the light transmittance is equal to or higher than 20%, and is preferably equal to or higher than 30% in a wavelength of 550 nm.

The term "opaque" indicates that the light emitting layer 32 has opacity or reflectivity with respect to light radiated therefrom. The term "opaque" does not limit the light transmittance thereof to be 0%. The term "opaque" also indicates a case where the light transmittance is relatively lower than a "transparent" region. For example, the term "opaque" denotes that the light transmittance is equal to or lower than 20%, and is preferably equal to or lower than 15% in the wavelength of 550 nm.

In the example described herein, the second electrode 22 has a thickness through which light radiated from the light emitting layer 32 cannot be substantially transmitted. For example, the second electrode 22 has high reflectivity with respect to light. Light which is radiated from the light emitting layer 32 and is oriented toward the second electrode 22 side is reflected by the second electrode 22, thereby passing through the first electrode 21 having the light transmission property. In the light emitting panel 10, light radiated from the light emitting layer 32 is guided out from the substrate 20 side.

For example, the sealing member 24 has the light transmission property. For example, the sealing member 24 transmits light emitted from the organic layer 30. As the sealing member 24, at least any one of the glass substrate and the transparent resin substrate is adopted. According to the embodiment, the sealing member 24 may have a non-light transmission property. For example, a resin is adopted as the sealing body 25.

In order to cause the light emitting surface 10c to have a circular shape and the like, the insulation film 26 is patterned in a circular shape by photolithography and the like, thereby regulating the light emitting surface 10c through the insulation film 26. Since substrates have tetragonal outer shapes, a ratio of an area of the light emitting surface 10c to an area of the substrate is lowered. When the outer shape thereof is caused to be the circular shape, the light emitting panel 10 is cut in an arbitrary shape such as the circular shape or a star shape by using the scribe apparatus. In such a case, the scribe apparatus is controlled based on the shape including a circular-shaped arc, the star shape, or the like. Compared to a case of cutting the light emitting panel 10 in a tetragonal shape, the controlling of the scribe apparatus may be complicated. In order to form the light emitting panel 10 to have the circular shape, there is a need to consider a structure of the elements such as wiring to the electrodes provided inside the light emitting panel 10.

Since the light emitting panel 10 has the above-described structure, while being off, the second surface 10b side is transmitted when the light emitting panel 10 is seen from the first surface 10a side, and the first surface 10a side is transmitted when the light emitting panel 10 is seen from the second surface 10b side. Meanwhile, while being on, the first surface 10a emits light, and the first surface 10a side is transmitted when the light emitting panel 10 is seen from the second surface 10b side. Thus, a transparent single surface irradiation type panel is obtained.

According to the embodiment described herein, the first surface 10a can emit light in arbitrary shapes such as the circular shape by providing the reflection portion 43 on the first surface 10a side of the single-sided light emitting panel.

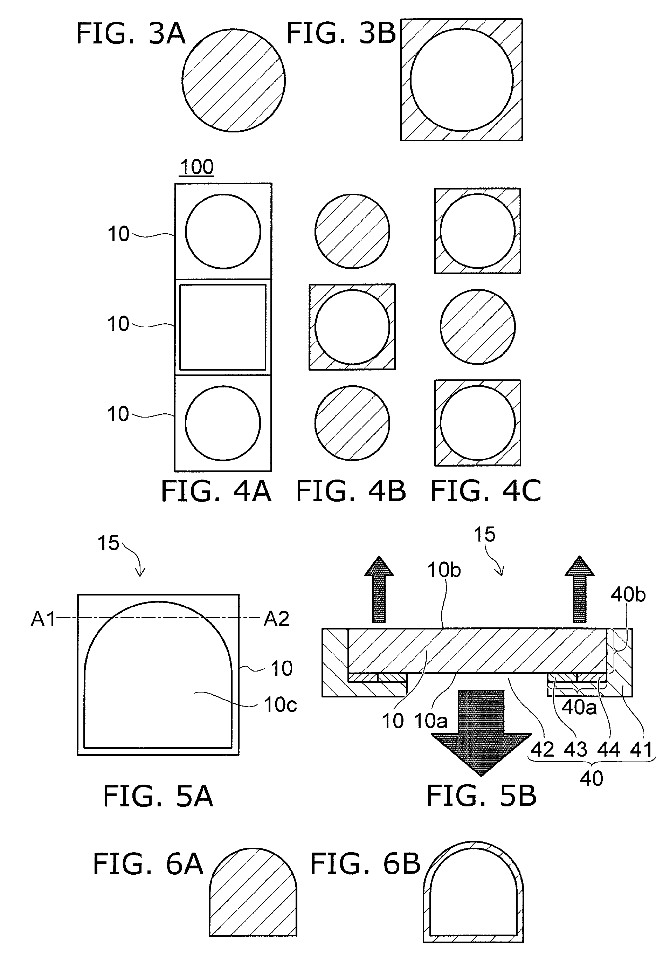

FIGS. 3A and 3B are another set of schematic diagrams exemplifying the light emitting module according to the first embodiment.

FIG. 3A describes light emissions of the first surface 10a when emitting light in a case of FIG. 1A. FIG. 3B describes light emissions of the second surface 10b when emitting light in a case of FIG. 1A. The diagonal lines in the drawing indicate the portions emitting light. FIGS. 3A and 3B are diagrams seen from the first surface 10a side and the second surface 10b side while being on.

As illustrated in FIG. 3A, the first surface 10a side can emit light from a region where the reflection portion 43 is not formed. For example, the first surface 10a side can emit light in an arbitrary shape such as the circular shape. The light emissions can be easily achieved from the light emitting surface 10c that is formed to have an arbitrary shape such as the circular shape by forming the opening portion 42 of the casing 40 to have a shape different from the shape of the light emitting panel 10 (for example, a tetragonal shape).

Meanwhile, the second surface 10b side of the single-sided light emitting panel which does not usually emit light can emit light on account of the reflection portion 43. The light emissions depend on the shape of the reflection portion 43. In other words, as illustrated in FIG. 3A, a region of the second surface 10b facing the reflection portion 43 emits light. However, regarding the light emissions in the region of the second surface 10b, light is emitted from the second surface 10b via the first electrode 21, the organic layer 30, and the second electrode 22, and thus, the light emission luminance therein becomes lower than that of the first surface 10a due to losses through reflecting and transmitting of light. While emitting light, through the region not facing the reflection portion 43, that is, the region emitting light in the first surface 10a, the first surface 10a side can be visually recognized from the second surface 10b side via the light emitting panel 10.

In this manner, according to the embodiment described herein, a light emitting module in which light can be easily emitted in a desired shape while performing up-to-date light emissions can be realized.

FIGS. 4A to 4C are a set of schematic diagrams exemplifying the lighting apparatus according to the first embodiment.

FIG. 4A illustrates a lighting apparatus 100. FIG. 4B illustrates light emissions of the first surface 10a when emitting light in a case of FIG. 4A. FIG. 4C illustrates light emissions of the second surface 10b in a case of FIG. 4A. The diagonal lines in the drawing indicate the portions emitting light. FIGS. 4B and 4C are diagrams seen from the first surface 10a side and the second surface 10b side while being on.

As illustrated in FIGS. 4A to 4C, for example, a plurality of the light emitting panels 10 which are respectively accommodated in the casings 40 are arranged on a plane, thereby forming the lighting apparatus 100. In the embodiment described herein, three of the light emitting panels 10 of the first embodiment are vertically arranged, and the light emitting panel 10 in the middle thereamong is arranged with the first surface 10a and the second surface 10b inverted. Therefore, the first surface 10a and the second surface 10b of the lighting apparatus 100 individually emit light as in the drawing. The number and an arrangement layout of the light emitting panel 10 are not limited to the example illustrated in FIGS. 4A to 4C.

According to the embodiment described herein, a light emitting module and a lighting apparatus in which light can be easily emitted in a desired shape while up-to-date light emissions can be achieved are provided.

### Second Embodiment

FIGS. 5A and 5B are a set of schematic diagrams exemplifying the light emitting module according to a second embodiment.

FIGS. 6A and 6B are another set of schematic diagrams exemplifying the light emitting module according to a second embodiment.

FIG. 5A is a schematic plan view exemplifying the light emitting module 15. FIG. 5B exemplifies a cross section taken along line A1-A2 of FIG. 5A. FIG. 6A illustrates light emissions of the first surface 10a when emitting light in a case of FIG. 5A. FIG. 6B illustrates light emissions of the second surface 10b in a case of FIG. 5A. The diagonal lines in the drawing indicate the portions emitting light. FIGS. 6A and 6B are diagrams seen from the first surface 10a side and the second surface 10b side while being on.

As illustrated in FIG. 5A, the light emitting surface 10c of the light emitting panel 10 has a shape including an arc, for example. The first surface 10a of the light emitting panel 10 has the tetragonal shape. The opening portion 42 of the casing 40 is formed to have a shape including an arc, and thus, the light emitting surface 10c of the light emitting panel 10 is formed to have the shape including an arc.

The light emitting panel 10 of which the light emitting surface 10c has the shape including an arc and the light emitting panel 10 of which the light emitting surface 10c has the tetragonal shape may be arranged.

In the light emitting module 15, the reflection portion 43 is formed on the first surface 40a of the casing 40 so as to face a portion on the first surface 10a of the light emitting panel 10. For example, the reflection portion 43 is formed between the light emitting panel 10 and the body portion 41 so as to come into contact with the portion on the first surface 10a of the light emitting panel 10. A light absorption portion 44 is formed outside the reflection portion 43. The reflection portion 43 and the light absorption portion 44 are formed inside the casing 40 that is installed on the irradiation surface side of the light emitting panel 10.

In the embodiment described herein, during a turned-on state, the first surface 10a and the second surface 10b respectively exhibit light emissions as illustrated in FIGS. 6A and 6B. The second surface 10b is configured to cause an outer edge having a shape in which a tetragonal shape and a semicircular shape are combined to emit light in a line form, on account of the light absorption portion 44.

For example, the reflection portion 43 is formed to have an arbitrary shape on the first surface 40a of the casing 40 so as to face at least one corner portion on the first surface 10a of the light emitting panel 10. In the embodiment described herein, the reflection portion 43 is formed on the first surface 40a of the casing 40 so as to face the corner portions on the first surface 10a of the light emitting panel 10.

According to the embodiment described herein, a light emitting module and a lighting apparatus in which light can be easily emitted in a desired shape while up-to-date light emissions can be achieved are provided.

Hereinbefore, the exemplary embodiments are described with reference to specification examples. However, the embodiments described herein are not limited to the specification examples. For example, specific configurations for each of the elements such as the light emitting panel, the light emitting module, the substrate, the light emitting layer, the organic layer, the sealing member, the casing, and the reflection portion provided in the lighting apparatus are included within the scope of the embodiments described herein as long as the embodiments described herein can be similarly embodied and can achieve the similar effect thereof by those skilled in the art through appropriate selection from the known range.

A combination which includes any of two or more elements in each of the specification examples and is carried out within a technically possible range is included in the scope of the embodiments described herein as long as the gist of the embodiments described herein is included therein.

Moreover, based on the lighting apparatus described above as the exemplary embodiments described herein, all the lighting apparatuses which can be embodied by those skilled in the art through appropriately changing the design also belong to the embodiments described herein as long as the gist of the embodiments described herein is included therein.

Furthermore, regarding the scope of the idea of the embodiments described herein, those skilled in the art can conceive various changed and modified examples, and thus, the changed and modified examples are also understood to belong to the scope of the embodiments described herein.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A light emitting module (15) comprising:
a light emitting panel (10) that includes a first electrode (21), a second electrode (22) facing the first electrode (21) and having a power supply portion (22a) and a light transmission portion (22b), and an organic layer (30) being provided between the first electrode (21) and the second electrode (22) and having a light emitting layer (32); and
a reflection portion (43) that is provided so as to face the first electrode (21) of the light emitting panel (10).

2. The module (15) according to Claim 1,
wherein the light emitting panel (10) has a first surface (10a) which is positioned on a first electrode (21) side, and a second surface (10b) which is positioned on a second electrode (22) side,
wherein while being off, a second surface (10b) side is transmitted when the light emitting panel (10) is seen from a first surface (10a) side, and the first surface (10a) side is transmitted when the light emitting panel (10) is seen from the second surface (10b) side, and
wherein while being on, the first surface (10a) emits light, and the first surface (10a) side is transmitted when the light emitting panel (10) is seen from the second surface (10b) side.

3. The module (15) according to Claim 2,
wherein the reflection portion (43) has specular reflectivity, specularly reflects light which is emitted from the first surface (10a), and emits the light from the second surface (10b) via the first electrode (21), the organic layer (30), and the second electrode (22).

4. The module (15) according to Claim 3,
wherein the reflection portion (43) is provided so as to come into contact with the first surface (10a), and
wherein while being on, the first surface (10a) emits light from a region where the reflection portion (43) is not formed, the second surface (10b) emits light from a region facing the reflection portion (43), and the first surface (10a) side is transmitted to be seen in a region not facing the reflection portion (43).

5. A lighting apparatus (100) which includes the module (15) according to any one of Claims 1 to 4.
